(19) Europäisches Patentamt
European Patent Office
Office européen des brevets

(11) **EP 3 655 788 B1**

(12) **FASCICULE DE BREVET EUROPEEN**

(45) Date de publication et mention
de la délivrance du brevet:
**05.05.2021 Bulletin 2021/18**

(21) Numéro de dépôt: **18739553.8**

(22) Date de dépôt: **17.07.2018**

(51) Int Cl.:
*G01R 31/396* (2019.01)        *G01R 19/165* (2006.01)
*H02J 7/00* (2006.01)

(86) Numéro de dépôt international:
**PCT/EP2018/069414**

(87) Numéro de publication internationale:
**WO 2019/016218 (24.01.2019 Gazette 2019/04)**

(54) **PROCEDE DE DETECTION D'UN DEFAUT D'AUTODECHARGE DANS UNE CELLULE DE BATTERIE**

VERFAHREN ZUR ERKENNUNG EINES SELBSTENTLADUNGSDEFEKTS IN EINER BATTERIEZELLE

METHOD FOR DETECTING A SELF-DISCHARGE DEFECT IN A BATTERY CELL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.07.2017 FR 1756838**

(43) Date de publication de la demande:
**27.05.2020 Bulletin 2020/22**

(73) Titulaire: **Renault S.A.S.**
**92100 Boulogne-Billancourt (FR)**

(72) Inventeurs:
• **MENSLER, Michel**
**78180 Montigny le Bretonneux (FR)**
• **DELOBEL, Bruno**
**92130 Issy les Molineaux (FR)**
• **DRIEMEYER, Franco Ana Lucia**
**78180 Montigny le Bretonneux (FR)**
• **ARSAC, Benoit**
**78000 Versailles (FR)**
• **ORIGUCHI, Masato**
**78120 Rambouillet (FR)**

(56) Documents cités:
**AU-A1- 2004 203 624        CN-A- 105 527 583
CN-A- 106 908 727        DE-A1-102012 214 878**

**Description**

L'invention concerne le contrôle d'une batterie d'accumulation électrique comportant une pluralité de cellules, en particulier destinée à être incorporée dans un véhicule automobile.

Les véhicules automobiles à propulsion électrique comprennent notamment les véhicules à propulsion purement électrique, les véhicules hybrides ou les véhicules hybrides rechargeables. De tels véhicules sont équipés d'une batterie d'accumulation électrique comportant un grand nombre de cellules de batteries. Ces cellules peuvent être montées en série et/ou en parallèle.

De manière générale, les cellules constituant une batterie d'accumulation électrique ont des caractéristiques proches les unes des autres. Toutefois, il arrive au cours de la vie de la batterie que ces cellules présentent des dispersions ou différences. Par exemple, il peut exister une dispersion de la capacité des cellules, une dispersion de la résistance des cellules, ou encore, de manière temporaire, une dispersion de l'état de charge des cellules ou une dispersion de la température des cellules. Ces dispersions ont pour effet un vieillissement différent pour chaque cellule d'une batterie d'accumulation électrique et une dispersion de l'état de santé des cellules.

La batterie d'accumulation électrique dans son ensemble est directement impactée par les dispersions relatives aux cellules qui la constituent, en particulier par les dispersions d'état de charge. En effet, plus la différence de charge entre les cellules est grande, plus la capacité totale utilisable de la batterie diminue.

Pour pallier cet inconvénient, on procède généralement à un équilibrage des cellules de manière régulière. Cet équilibrage peut être assuré par un système de gestion de la batterie directement et de manière autonome. Par exemple, l'équilibrage des cellules peut être dissipatif, consistant à équilibrer les états de charge des cellules en déchargeant les cellules dans une résistance vers un état de charge cible. Grâce à cette solution, la dispersion de l'état de charge peut être maintenue inférieure à un seuil, permettant de limiter la chute de la capacité totale utilisable de la batterie.

Cette solution n'apporte toutefois pas pleinement satisfaction. En effet, il arrive que les cellules d'une batterie d'accumulation électrique rencontrent des problèmes internes provoquant une autodécharge qui augmente rapidement au cours du temps. Cette autodécharge augmente la dispersion de l'état de charge entre les cellules de batterie. Lorsque l'autodécharge devient trop importante, le système d'équilibrage perd de son efficacité et devient finalement incapable de compenser la dispersion de l'état de charge entre les cellules de la batterie d'accumulation électrique. Il en résulte généralement une chute importante et rapide de la capacité de la batterie d'accumulation électrique, voire une panne d'une cellule entraînant une panne de la batterie d'accumulation électrique dans son ensemble.

Le document CN 105527583 décrit un procédé de détection de l'autodécharge dans un pack batterie dans lequel on déduit un défaut d'autodécharge d'une cellule de batterie si la tension aux bornes de la cellule varie de manière importante entre deux instants prédéfinis. Bien qu'un tel procédé puisse permettre la détection d'un défaut d'autodécharge dans une cellule, il arrive encore que des défauts d'autodécharge ne soient pas détectés et/ou que des fausses alertes de défaut d'autodécharge soient émises. Ainsi, il existe un besoin de proposer un procédé plus fiable pour détecter un défaut d'autodécharge.

En outre, le procédé décrit dans le document CN 105527583 nécessite un long temps de relaxation des cellules entre les deux instants de mesure de la tension. Le procédé ne peut alors être mis en œuvre que lors de longues périodes d'inactivité du véhicule, par exemple lors d'un stockage du véhicule sur un parking. De telles pauses arrivent rarement. La détection d'un défaut d'autodécharge est alors tardive, voire impossible

D'autres documents pertinents sont AU 2004 203 624, DE 10 2012 214878 et CN 106 908 727.

Au vu de ce qui précède, l'invention a pour but de détecter à un stade précoce un défaut d'autodécharge d'une cellule d'une batterie d'accumulation électrique de sorte à éviter une dispersion de l'état de charge entre les cellules.

À cet effet, il est proposé un procédé de détection, dans une batterie d'accumulation électrique comportant une pluralité de cellules de batterie, d'un défaut d'autodécharge dans une cellule, dans lequel :

- on met en œuvre au moins partiellement un équilibrage des charges des cellules de batterie,
- on réalise une relaxation des cellules de batterie,
- on calcule, pour chaque cellule de batterie, un bilan des charges au cours de l'équilibrage et de la relaxation de ladite cellule, et
- on détecte, pour chaque cellule de batterie, s'il existe un défaut d'autodécharge de ladite cellule en fonction du bilan des charges au cours de l'équilibrage et de la relaxation calculé pour ladite cellule.

Ainsi, un défaut d'autodécharge d'une cellule est détecté par une analyse de l'efficacité de l'équilibrage des cellules de la batterie. Il en résulte une détection plus fiable d'un défaut d'autodécharge dans chacune des cellules de cette batterie.

Avantageusement, pour chaque cellule de batterie, on calcule le bilan des charges au cours de l'équilibrage et de la relaxation de ladite cellule en tenant compte d'au moins une grandeur choisie parmi la charge à équilibrer pour ladite cellule immédiatement avant le début de l'équilibrage de ladite cellule, la charge à équilibrer pour ladite cellule immédiatement après la fin de la relaxation de ladite cellule, la quantité de charge déchargée pour ladite cellule au cours de l'équilibrage.

De préférence, quelle que soit une cellule de batterie, on calcule le bilan des charges au cours de l'équilibrage et de la relaxation de ladite cellule en appliquant la relation suivante :

$$\Sigma_i = q_{i,bal}(t_2) + \Delta q_i(T) - q_{i,bal}(t_1)$$

où « $\Sigma_i$ » désigne le bilan des charges au cours de l'équilibrage et de la relaxation de ladite cellule,
« $q_{i,bal}(t)$ » désigne la charge à équilibrer pour ladite cellule à un instant t,
« $\Delta q_i(T)$ » désigne la quantité de charge déchargée pour ladite cellule pendant un intervalle T,
« $t_1$ » désigne un instant situé immédiatement avant le début de l'équilibrage de ladite cellule,
« $t_2$ » désigne un instant situé immédiatement après la fin de la relaxation de ladite cellule, et
« T » désigne la durée pendant laquelle l'équilibrage des charges de la cellule a été mis en œuvre.

Dans un mode de mise en œuvre, pour chaque cellule, l'équilibrage comprend une étape de calcul d'une charge à équilibrer pour ladite cellule, et une étape de mise en œuvre de l'équilibrage dans laquelle on calcule la quantité de charge déchargée pour ladite cellule, et on poursuit l'étape d'équilibrage tant que la charge à équilibrer pour ladite cellule est strictement supérieure à la quantité de charge déchargée pour ladite cellule.

Ce mode de mise en œuvre, dans lequel on compare une charge prévisionnelle à équilibrer avec une quantité de charge effectivement déchargée, permet un équilibrage particulièrement précis. On améliore ainsi la précision de la détection d'un défaut d'autodécharge.

Dans un autre mode de mise en œuvre, pour chaque cellule, l'équilibrage comprend une étape de calcul d'une charge à équilibrer pour ladite cellule, une étape de calcul d'un temps d'équilibrage de ladite cellule en fonction de la charge à équilibrer pour ladite cellule calculée, et dans lequel on met en œuvre l'équilibrage pendant le temps d'équilibrage calculé.

Ce mode de mise en œuvre, fondé sur le calcul d'un temps d'équilibrage prévisionnel, nécessite relativement peu de ressources de calcul pour détecter un défaut d'autodécharge.

De manière avantageuse, on calcule, pour chaque cellule, une charge à équilibrer pour ladite cellule en fonction d'au moins un paramètre choisi parmi un état de charge de ladite cellule, un état de charge d'une cellule cible, une capacité de ladite cellule, une capacité d'une cellule cible, un état de santé de ladite cellule, un état de santé d'une cellule cible, une tension à courant nul de ladite cellule, une tension à courant nul d'une cellule cible, une capacité nominale de ladite cellule et une capacité nominale d'une cellule cible.

De préférence, on calcule, pour chaque cellule, une quantité de charge déchargée pour ladite cellule pendant une durée en fonction d'au moins un paramètre choisi parmi une résistance d'équilibrage, une tension aux bornes de ladite cellule à un instant appartenant à ladite durée, une intensité d'équilibrage des cellules de la batterie d'accumulation électrique et une tension nominale des cellules de la batterie d'accumulation électrique.

Dans un mode de mise en œuvre, on détecte qu'il existe un défaut d'autodécharge dans une première cellule de batterie si, quelle que soit une seconde cellule de batterie autre que la première cellule de batterie, la charge à équilibrer par ladite seconde cellule immédiatement après la fin de la relaxation de ladite seconde cellule est strictement supérieure à la charge à équilibrer par ladite seconde cellule immédiatement avant le début de l'équilibrage de ladite seconde cellule et la quantité de charge déchargée par ladite seconde cellule au cours de l'équilibrage et de la relaxation est différente de zéro.

Un tel mode de mise en œuvre permet de détecter un défaut d'autodécharge dans la cellule de batterie dont l'état de charge correspond à un état de charge d'une cellule cible.

On peut également prévoir, pour chaque cellule, de détecter qu'il existe un défaut d'autodécharge dans ladite cellule si le bilan des charges au cours de l'équilibrage et de la relaxation calculé pour ladite cellule dépasse un seuil strictement positif, ledit seuil étant déterminé en fonction d'au moins une erreur choisie parmi une erreur sur la charge à équilibrer pour ladite cellule immédiatement avant le début de l'équilibrage de ladite cellule, une erreur sur la charge à équilibrer pour ladite cellule immédiatement après la fin de la relaxation de ladite cellule, une erreur sur la quantité de charge déchargée pour ladite cellule au cours de l'équilibrage et de la relaxation.

L'application d'un tel seuil permet de prendre en compte des sources d'imprécision liées à la batterie d'accumulation électrique qui empêcheraient une détection ou qui, au contraire, provoqueraient une détection injustifiée.

Avantageusement, quelle que soit une cellule, ledit seuil est déterminé en fonction d'une erreur sur la charge à équilibrer pour ladite cellule, ladite erreur étant calculée, pour tout instant, selon l'expression suivante :

$$\delta q_{i,bal} = |Q_i.\,\delta SOC_i| + |SOC_i.\,\delta Q_i| + |Q_{cible}.\,\delta SOC_{cible}| + |SOC_{cible}.\,\delta Q_{cible}|$$

où « $\delta q_{i,bal}$ » représente l'erreur sur la charge à équilibrer par ladite cellule audit instant,

« $\delta SOC_i$ » représente l'erreur sur l'état de charge de ladite cellule,

« $\delta Q_i$ » représente l'erreur sur la charge de ladite cellule,

« $SOC_i$ » représente l'état de charge de ladite cellule audit instant,

« $Q_i$ » représente la charge de ladite cellule audit instant,

« $\delta SOC_{cible}$ » représente l'erreur sur l'état de charge de la cellule cible,

« $\delta Q_{cible}$ » représente l'erreur sur la charge de la cellule cible,

« $SOC_{cible}$ » représente l'état de charge de la cellule cible audit instant, et

« $Q_{cible}$ » représente la charge de la cellule cible audit instant.

De préférence, quelle que soit une cellule, ledit seuil est déterminé en fonction d'une erreur sur la quantité de charge déchargée pour ladite cellule pendant un intervalle, ladite erreur étant calculée en utilisant l'expression suivante :

$$\delta\Delta q_i(T) = \left| \frac{1}{R_{bal}{}^2}.\int_0^T V_i(\tau)\,d\tau.\,\delta R_{bal} \right|$$

où « T » représente ledit intervalle,

« $\delta\Delta q_i(T)$ » représente l'erreur sur la quantité de charge déchargée pour ladite cellule pendant ledit intervalle,

« $R_{bal}$ » représente la résistance utilisée pour l'équilibrage et,

quel que soit un instant $\tau$ appartenant audit intervalle, « $V_i(\tau)$ » désigne la tension mesurée aux bornes de ladite cellule à l'instant $\tau$.

On peut également prévoir, quelle que soit une cellule, de déterminer ledit seuil en fonction d'une erreur sur la quantité de charge déchargée pour ladite cellule pendant un intervalle, ladite erreur étant calculée en utilisant l'expression suivante :

$$\delta\Delta q_i(T) = |T.\,\delta I_{bal}|$$

où « T » représente ledit intervalle,

« $\delta\Delta q_i(T)$ » représente l'erreur sur la quantité de charge déchargée pour ladite cellule pendant ledit intervalle, et

« $\delta I_{bal}$ » représente l'erreur sur le courant d'équilibrage des cellules de la batterie d'accumulation électrique.

Comme cela sera expliqué par la suite, on tient compte par ces calculs d'erreur de la plupart des imprécisions rencontrées par une batterie d'accumulation électrique. On parvient ainsi à affiner le calcul du seuil et donc à améliorer la fiabilité de la détection du défaut d'autodécharge.

D'autres buts, caractéristiques et avantages de l'invention apparaîtront à la lecture de la description suivante, donnée uniquement à titre d'exemple non limitatif, et faite en référence aux dessins annexés sur lesquels :

-    la figure 1 représente schématiquement une batterie d'accumulation électrique,
-    la figure 2 représente schématiquement un procédé de détection selon un exemple de réalisation de l'invention,
-    la figure 3 représente trois graphiques illustrant le calcul des charges à équilibrer pour une cellule de la batterie de la figure 1,
-    la figure 4 représente un graphique illustrant le bilan des charges au cours d'un équilibrage et d'une relaxation d'une cellule de la batterie de la figure 1 selon un premier cas de fonctionnement, et
-    la figure 5 représente un graphique illustrant le bilan des charges au cours d'un équilibrage et d'une relaxation d'une cellule de la batterie de la figure 1 selon un second cas de fonctionnement.

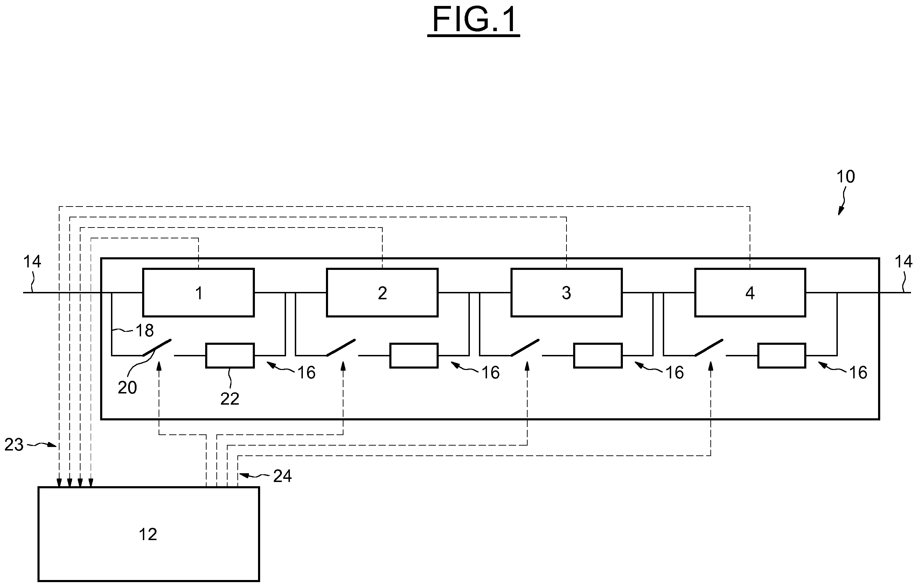

En référence à la figure 1, il est schématiquement représenté une batterie d'accumulation électrique 10. La batterie 10 est destinée à être incorporée dans un véhicule automobile à propulsion électrique pour alimenter une machine électrique de traction appartenant au groupe motopropulseur du véhicule automobile.

La batterie 10 comporte deux bornes 14. La batterie 10 comporte quatre cellules de batterie respectivement référencées 1, 2, 3 et 4. Dans l'exemple illustré, les cellules 1, 2, 3 et 4 sont connectées en série. Toutefois, on ne sort pas du cadre de l'invention en envisageant des cellules connectées en parallèle, ou encore une partie des cellules connectée en parallèle et le reste des cellules connecté en série. De même, on ne sort bien entendu pas du cadre de l'invention en envisageant un nombre différent de cellules.

La batterie 10 est en liaison d'information avec un système de gestion 12. Le système de gestion 12 est également connu sous l'expression anglo-saxonne « battery management system » ou par l'acronyme « BMS ». Le système 12 assure la gestion de différents procédés mis en œuvre au cours de la vie de la batterie 10. Par exemple, comme cela sera expliqué par la suite, le système de gestion 12 assure la gestion d'un procédé d'équilibrage des cellules de la batterie 10.

Chacune des cellules 1, 2, 3, 4 est respectivement associé à un circuit d'équilibrage 16. Dans l'exemple illustré, les circuits d'équilibrage 16 sont identiques pour toutes les cellules de la batterie 10. Quelle que soit une cellule 1, 2, 3 ou 4, le circuit d'équilibrage 16 associé à cette cellule comporte un circuit électrique 18 raccordé aux deux bornes de cette cellule. Sur le circuit électrique 18, un interrupteur 20 et une résistance d'équilibrage 22 sont montés en série. Toutefois, l'invention ne se limite pas à cette forme du circuit d'équilibrage. En particulier, on peut tout aussi bien envisager un unique circuit d'équilibrage commun à toutes les cellules de la batterie 10 et apte à mettre en œuvre séparément l'équilibrage de l'une des cellules.

Le système 12 est doté de moyens matériels et logiciels pour recevoir des données relatives aux cellules 1, 2, 3 et 4, comme cela est représenté par les flèches pointillées 23. Le système 12 est doté de moyens matériels et logiciels pour déterminer à partir des données reçues des données intermédiaires relatives aux cellules 1, 2, 3 et 4.

Par exemple, quelle que soit une cellule i choisie parmi les cellules 1, 2, 3 et 4, le système 12 est apte à recevoir la tension $v_i$ aux bornes de la cellule i et l'intensité $I_{i,bal}$ traversant la cellule i lors de l'équilibrage de cette cellule i. Le système 12 est capable de déterminer la tension à courant nul $OCV_i$ de la cellule i, également connue sous l'expression anglo-saxonne « open circuit voltage » et l'état de charge $SOC_i$ de la cellule i, également connu sous l'expression anglo-saxonne « state of charge ».

Comme cela est représenté par les flèches pointillées 24, le système 12 est doté des moyens matériels et logiciels pour commander l'ouverture et la fermeture des interrupteurs 20 associés respectivement aux cellules 1, 2, 3 et 4. De ce fait, quelle que soit une cellule i avec i compris entre 1 et 4, lorsque le système 12 considère que l'équilibrage de la cellule i doit être mis en œuvre, il actionne la fermeture de l'interrupteur 20 du circuit d'équilibrage 16 correspondant à la cellule i. De l'énergie électrique libérée par la cellule i est dissipée dans la résistance d'équilibrage 22 du circuit d'équilibrage 16 associé à la cellule i. Lorsque le système de gestion 4 considère que l'équilibrage de la cellule i doit s'arrêter, il actionne l'ouverture de l'interrupteur 20 du circuit d'équilibrage 16 associé à la cellule i.

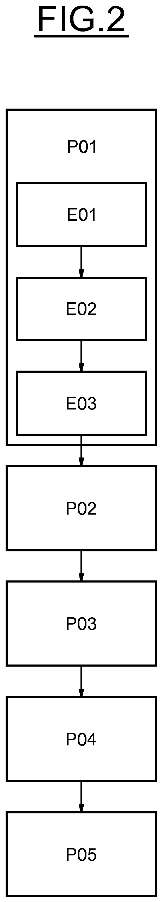

En référence aux figures 2 à 5, il va maintenant être décrit la mise en œuvre d'un procédé de détection d'un défaut d'autodécharge selon l'invention. Le procédé est mis en œuvre pour détecter un défaut d'autodécharge dans les cellules 1, 2, 3 et 4 de la batterie 10 au moyen du système de gestion 12. Un exemple de mise en œuvre du procédé selon l'invention est schématiquement illustré sur la figure 2.

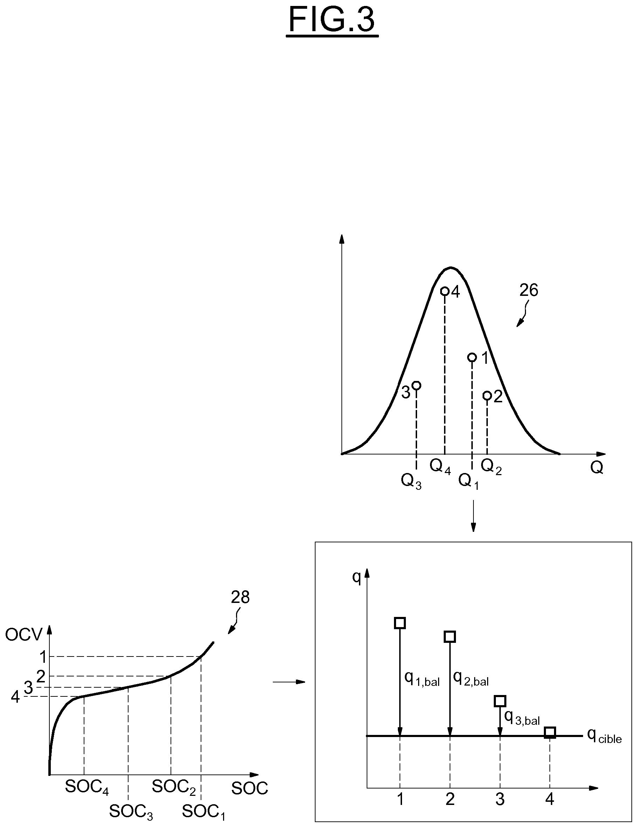

Le procédé selon l'invention comporte une première phase P01 d'équilibrage des charges des cellules de la batterie 10. Lors de la description de la phase P01, on pourra se référer à la figure 3 qui illustre un premier graphique 26 de la distribution des capacités $Q_1$, $Q_2$, $Q_3$ et $Q_4$ des cellules respectives 1, 2, 3 et 4. Les capacités sont représentées dans une distribution d'une courbe de Gauss. La figure 3 contient un second graphique 28 illustrant la relation entre la tension à courant nul OCV des cellules 1, 2, 3 et 4 en fonction de l'état de charge SOC desdites cellules.

La phase P01 comprend une première étape E01 dans laquelle on détermine des paramètres cibles. Plus précisément, on détermine un état de charge cible $SOC_{cible}$ et une capacité cible $Q_{cible}$. Dans l'exemple illustré, l'état de charge cible $SOC_{cible}$ et la capacité cible $Q_{cible}$ sont définis comme étant l'état de charge $SOC_i$ et la capacité $Q_i$ de la cellule i ayant le plus faible état de charge. Dans le cas de la figure 3, l'état de charge cible $SOC_{cible}$ correspond à l'état de charge $SOC_4$ de la cellule 4 et la capacité cible $Q_{cible}$ est définie égale à la capacité $Q_4$ de la cellule 4 :

$$\begin{bmatrix} SOC_{cible} = SOC_4 \\ Q_{cible} = Q_4 \end{bmatrix} \quad (1)$$

La phase P01 comprend une deuxième étape E02 dans laquelle on calcule la charge prévisionnelle à équilibrer pour les cellules de la batterie 10. Quelle que soit une cellule i, la charge prévisionnelle à équilibrer $q_{i,bal}$ pour la cellule i correspond à la charge devant être déchargée dans la résistance 22 du circuit d'équilibrage 16 associé à la cellule i pour équilibrer la cellule i par rapport à la cellule cible. Pour ce faire, on peut appliquer l'équation :

$$q_{i,bal} = SOC_i \times Q_i - SOC_{cible} \times Q_{cible} \quad (2)$$

Dans l'exemple illustré, on suppose avantageusement qu'il n'y a pas de dispersion entre les capacités des cellules de la batterie 10. De ce fait, en notant Q la capacité de toutes les cellules, la charge $q_{i,bal}$ peut être calculée par l'application de l'équation :

$$q_{i,bal} = (SOC_i - SOC_{cible}) \times Q \quad (3)$$

Le procédé selon l'invention ne se limite pas au calcul qui vient d'être décrit à titre d'exemple. Selon un premier exemple de variante, quelle que soit une cellule i, il est possible sans sortir du cadre de l'invention de calculer la charge $q_{i,bal}$ en appliquant l'équation

$$q_{i,bal} = f(OCV_i) \times (SOH_i \times Q_{i,nom}) - f(OCV_{cible}) \times (SOH_{cible} \times Q_{cible,nom}) \quad (4)$$

Dans cette équation, la fonction f désigne la fonction dont la représentation graphique correspond au graphique 28 de la figure 3, $SOH_i$ désigne l'état de santé de la cellule i, également connu sous la dénomination anglo-saxonne « state of health », $Q_{i,nom}$ désigne la capacité nominale de la cellule i, $SOH_{cible}$ désigne l'état de santé cible et $Q_{cible,nom}$ désigne la capacité nominale cible. Par exemple, l'état de santé cible $SOH_{cible}$ et la capacité nominale cible $Q_{cible,nom}$ sont respectivement l'état de santé et la capacité nominale de la cellule cible, en l'espèce l'état de santé $SOH_4$ et la capacité nominale $Q_{4,nom}$ de la cellule 4.

L'équation selon le premier exemple de variante peut être notamment mise en œuvre lorsque le système de gestion 12 est doté de moyens pour déterminer les états de santé de chacune des cellules 1 à 4, individuellement.

Selon un deuxième exemple de variante du procédé selon l'invention, on peut choisir un mode de détermination différent de l'état de charge cible $SOC_{cible}$. Par exemple, l'état de charge cible $SOC_{cible}$ peut être la moyenne des états de charge des cellules de la batterie 10. Cela peut avoir pour conséquence que la charge prévisionnelle à équilibrer $q_{i,bal}$ d'une cellule i prenne des valeurs négatives. Toutefois, le système d'équilibrage étant dissipatif, il est impossible de recharger la cellule correspondante. Par conséquent, dans un tel cas, quelle que soit une cellule i, la charge prévisionnelle à équilibrer $q_{i,bal}$ est automatiquement définie égale à zéro lorsque le calcul de cette charge donne un résultat négatif.

Les charges prévisionnelles à équilibrer $q_{1,bal}$, $q_{2,bal}$, $q_{3,bal}$ et $q_{4,bal}$ des cellules respectives 1, 2, 3 et 4 sont schématiquement représentées sur le troisième graphique 30 de la figure 3. Le graphique 30 illustre, pour chaque cellule i choisie parmi les cellules 1, 2, 3 et 4, la charge $q_i$ de ladite cellule et la charge de la cellule cible, en l'espèce $q_4$. Pour chaque cellule i, i étant compris entre 1 et 4, la charge prévisionnelle à équilibrer $q_{i,bal}$ est représentée schématiquement par une flèche verticale orientée vers le bas. Comme visible sur le graphique 30, la charge prévisionnelle à équilibrer $q_{4,bal}$ de la cellule cible 4 est égale à zéro.

La phase P01 comprend une troisième étape E03 dans laquelle on met en œuvre l'équilibrage des cellules de la batterie 10. Pour ce faire, le système 12 actionne la fermeture de l'interrupteur 20 associé à chacune des cellules nécessitant d'être équilibrées. Dans le même temps, à chaque instant t et pour toute cellule i de la batterie 10, le système 12 calcule la quantité de charge effectivement déchargée $\Delta q_i(t)$ pour la cellule i à l'instant t. Quelle que soit une cellule i de la batterie 10, la quantité de charge effectivement déchargée par la cellule i à un instant t peut être calculée selon l'expression :

$$\Delta q_i(t) = \int_0^t I_{i,bal}(\tau) d\tau \quad (5)$$

Or, la loi d'Ohm s'écrit :

$$I_{i,bal}(t) = \frac{v_i(t)}{R_{bal}} \quad (6)$$

où $R_{bal}$ est la valeur de la résistance 22 des circuits d'équilibrage 16.

De la sorte, il est possible de calculer la quantité $\Delta q_i(t)$ en appliquant l'équation :

$$\Delta q_i(t) = \frac{1}{R_{bal}} \int\limits_0^t v_i(\tau) d\tau \quad (7)$$

Quelle que soit une cellule i de la batterie 10, le système 12 compare en permanence la charge prévisionnelle à équilibrer $q_{i,bal}$ avec la quantité de charge effectivement déchargée $\Delta q_i(t)$. Tant que la charge prévisionnelle à équilibrer $q_{i,bal}$ est strictement supérieure à la quantité de charge effectivement déchargée $\Delta q_i(t)$, l'interrupteur 20 reste fermé. Lorsque la charge $q_{i,bal}$ devient égale ou supérieure à la quantité $\Delta q_i(t)$, l'interrupteur 20 associé à la cellule i est ouvert. L'équilibrage de la cellule i est alors terminé.

La charge prévisionnelle à équilibrer $q_{4,bal}$ pour la cellule 4 étant nulle, il est impossible que la quantité de charge effectivement déchargée $\Delta q_4(t)$ par cette cellule soit strictement inférieure à la charge prévisionnelle à équilibrer, et ce quel que soit un instant t. En conséquence, dans l'exemple illustré, l'interrupteur 20 associé à la cellule 4 n'est pas fermé au cours de l'étape E03.

Selon un troisième exemple de variante du procédé selon l'invention, l'équilibrage peut être commandé sur la base d'un temps d'équilibrage calculé. Dans l'étape E02 de cet exemple de variante du procédé, quelle que soit une cellule i de la batterie 10, on utilise la charge prévisionnelle à équilibrer $q_{i,bal}$ pour la cellule i pour calculer un temps d'équilibrage $t_{i,bal}$ pour la cellule i. Ce temps d'équilibrage $t_{i,bal}$ pour la cellule i se calcule en appliquant l'équation :

$$t_{i,bal} = \frac{q_{i,bal}}{I_{i,bal}} \quad (8)$$

avec :

$$I_{i,bal} = \frac{V_{nom}}{R_{bal}} \quad (9)$$

où $V_{nom}$ est la tension nominale des cellules de la batterie 10.

Dans le troisième exemple de variante, la dispersion de la résistance d'équilibrage et de la tension nominale des cellules est supposée nulle. Ainsi, le courant d'équilibrage $I_{i,bal}$ est supposé identique pour toutes les cellules et est noté $I_{bal}$.

Au vu de ce qui précède, quelle que soit une cellule i de la batterie 10, le temps équilibrage $t_{i,bal}$ peut être calculé en appliquant la formule :

$$t_{i,bal} = \frac{q_{i,bal}}{I_{bal}} \quad (10)$$

Dans l'étape E03 du troisième exemple de variante, quelle que soit une cellule i de la batterie 10, le système 12 actionne l'interrupteur 20 associé à la cellule i dans un état fermé entre les instants $t_1$ et $t_i + t_{i,bal}$, où $t_1$ est l'instant de début de l'équilibrage.

Le troisième exemple de variante est avantageux en ce qu'il n'est pas nécessaire de calculer en permanence la quantité $\Delta q_i(t)$ pour toutes les cellules. En résultat, les besoins en ressources de calcul sont moins importants. Toutefois, l'équilibrage est rendu plus approximatif car on utilise dans le calcul du temps d'équilibrage la tension nominale des cellules, constante, au lieu de la tension réelle qui varie lors de l'utilisation de la batterie 10.

On peut, dans un quatrième exemple de variante, calculer différemment la quantité de charge effectivement déchargée $\Delta q_i(t)$ par une cellule i à un instant t. Dans ce quatrième exemple de variante, quelle que soit une cellule i, la quantité $\Delta q_i(t)$ est calculée en appliquant l'équation :

$$\Delta q_i(T) = I_{bal} \times t_{i,bal} \quad (11)$$

En règle générale, l'équilibrage n'est possible que durant la mission du véhicule, c'est-à-dire lorsque le véhicule est en roulage et en charge. Le temps d'équilibrage est alors souvent trop court pour assurer un équilibrage de toutes les cellules en une seule mission. Dans ce cas, l'équilibrage est interrompu et reprend à la suite d'une période d'interruption.

Dans l'exemple de mise en œuvre illustré, les paramètres cibles sont mis à jour lors de la reprise de l'équilibrage faisant suite à une interruption. Un tel choix est notamment avantageux en raison du fait que, à la reprise de l'équilibrage, les cellules sont susceptibles d'être à un état de charge élevé.

L'invention ne se limite toutefois pas à un tel choix et on peut envisager un cinquième exemple de variante dans lequel, lorsque l'équilibrage est repris faisant suite à une interruption, il n'est pas mis en œuvre une mise à jour des paramètres cibles. Ce cinquième exemple est avantageux en ce qu'il nécessite moins de ressources de calcul.

Le procédé de détection selon l'invention comporte, ensuite, pour chaque cellule de la batterie 10, une phase P02 de relaxation de la cellule. Au cours de la phase P02, l'intensité de la cellule est maintenue égale à zéro pendant un temps de relaxation $T_r$.

Dans l'exemple de mise en œuvre illustré, le temps de relaxation $T_r$ est calculé en fonction des temps d'équilibrage $t_{i,bal}$ des cellules de la batterie 10. Plus précisément, le temps $T_r$ est sensiblement égal à la moyenne des temps d'équilibrage $t_{i,bal}$ des cellules de la batterie 10 multiplié par un coefficient compris entre 0.5 et 1.

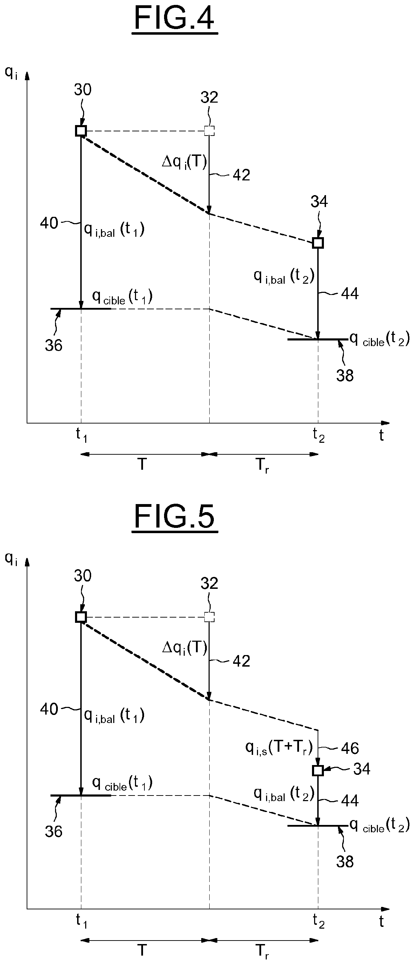

La figure 4 illustre l'évolution de la charge au cours du temps d'une cellule i de la batterie 10 subissant les phases d'équilibrage P01 et de relaxation P02 du procédé selon l'invention. La cellule i dont l'évolution de la charge est illustrée sur la figure 4 ne subit pas de perte de charge due à un défaut d'autodécharge.

L'équilibrage débute à un instant $t_1$ et est interrompu après l'écoulement d'une période d'équilibrage T. La période T peut être inférieure ou égale au temps d'équilibrage $t_{i,bal}$ calculé pour la cellule i. Lorsque l'équilibrage est interrompu, une relaxation de la cellule i est mise en œuvre jusqu'à un instant $t_2$.

Un carré 32 représente schématiquement la charge $q_i(t_1)$ de la cellule i à l'instant $t_1$. Un carré 34 illustre la charge $q_i(t_2)$ de la cellule i à l'instant $t_2$. Une ligne horizontale 36 représente la charge $q_{cible}(t_1)$ de la cellule cible à l'instant $t_1$. Une ligne horizontale 38 représente la charge $q_{cible}(t_2)$ de la cellule cible à l'instant $t_2$. Une première flèche verticale vers le bas 40 représente la charge prévisionnelle à équilibrer $q_{i,bal}(t_1)$ pour la cellule i estimée à l'instant $t_1$. Une seconde flèche verticale vers le bas 42 représente la quantité de charge effectivement déchargée $\Delta q_i(T)$ pour la cellule i au cours de l'équilibrage. Une troisième flèche verticale vers le bas 44 représente schématiquement la charge prévisionnelle à équilibrer $q_{i,bal}(t_2)$ pour la cellule i estimée à l'instant $t_2$.

Comme cela a été dit précédemment, la cellule i dans le cas de la figure 4 ne présente pas de défaut d'autodécharge. En conséquence, les données relatives à la charge de la cellule i respectent l'équation suivante :

$$q_{i,bal}(t_2) = q_{i,bal}(t_1) - \Delta q_i(T) \quad (12)$$

La figure 5 illustre l'évolution de la charge au cours du temps d'une cellule i subissant les mêmes phases d'équilibrage P01 et de relaxation P02 que dans la figure 4. La cellule i dont l'évolution de la charge est illustrée sur la figure 5 subit des pertes de charge dues à un défaut d'autodécharge significatif.

Comme sur la figure 4, l'équilibrage débute à un instant $t_1$ et est interrompu après l'écoulement d'une période d'équilibrage T, la cellule i étant ensuite relaxée jusqu'à un instant $t_2$.

Le graphique de la figure 5 diffère de celui de la figure 4 en ce qu'une quatrième flèche verticale vers le bas 46 représente schématiquement la quantité de charge déchargée due à l'autodécharge $\Delta q_{i,s}(T+T_r)$ de la cellule i au cours des phases P01 et P02 du procédé selon l'invention.

La cellule i dans le cas de la figure 5 présentant un défaut d'autodécharge, les données relatives à sa charge ne peuvent pas respecter l'équation (12). A la place, les données relatives à la charge de la cellule i dans le cas de la figure 5 respectent l'équation :

$$q_{i,bal}(t_2) = q_{i,bal}(t_1) - \Delta q_i(T) - \Delta q_{i,s}(T + T_r) \quad (13)$$

Dans un cas extrême, dans lequel la cellule i présente un défaut d'autodécharge très important, ou dans lequel l'intervalle d'équilibrage T et/ou l'intervalle de relaxation $T_r$ est très grand, il peut arriver que la quantité de charge déchargée entre les instants $t_1$ et $t_2$ soit supérieure à la charge prévisionnelle à décharger $q_{i,bal}(t_1)$ par la cellule i calculée à l'instant $t_1$. Dans ce cas :

$$q_{i,bal}(t_1) - \Delta q_i(T) - \Delta q_{i,s}(T + T_r) < 0 \quad (14)$$

Au vu de ce qui précède, quelle que soit une cellule i de la batterie 10, on peut détecter un défaut d'autodécharge de la cellule i en calculant le bilan des charges $\Sigma_i$ pour la cellule i par application de l'équation suivante :

$$\Sigma_i = q_{i,bal}(t_2) + \Delta q_i(T) - q_{i,bal}(t_1) \quad (15)$$

Dans un modèle théorique, quelle que soit une cellule i de la batterie 10, il n'existe pas de défaut d'autodécharge de la cellule i si le bilan $\Sigma_i$ est nul.

À l'inverse, quelle que soit une cellule i de la batterie 10, il existe un défaut d'autodécharge de la cellule i si un bilan $\Sigma_i$ strictement positif a été calculé. Dans ce cas, la quantité de charge déchargée due à l'autodécharge $\Delta q_{i,s}(T+T_r)$ de la cellule i peut être calculée en appliquant l'équation :

$$q_{i,s}(T + T_r) = q_{i,bal}(t_1) - q_{i,bal}(t_2) - q_i(T) \quad (16)$$

Le courant d'autodécharge $I_{i,s}$ de la cellule i peut être estimé en appliquant l'équation :

$$I_{i,s} = \frac{q_{i,s}(T + T_r)}{T + T_r} \quad (17)$$

Au vu de ce qui précède, il a été présenté un modèle théorique pour détecter l'existence d'un défaut d'autodécharge dans une cellule i de la batterie 10 par le calcul du bilan des charges $\Sigma_i$. Toutefois, ce modèle ne s'applique pas à la cellule cible. On va maintenant détailler un autre calcul mis en œuvre pour détecter un défaut d'autodécharge dans la cellule cible.

Pour ce calcul, on détecte si la cellule cible se décharge plus rapidement au cours du procédé de détection que les autres cellules de la batterie 10. Plus précisément, si, quelle que soit une cellule i de la batterie 10, la cellule i étant distincte de la cellule cible :

$$q_i(t_2) > q_i(t_1) \ \text{avec} \ q_i(T) \neq 0 \quad (18)$$

alors on relève un défaut d'autodécharge sur la cellule cible.

Le modèle théorique qui a été présenté permet donc de détecter un défaut d'autodécharge dans l'une quelconque des cellules de la batterie 10. En pratique, il est toutefois nécessaire d'appliquer un seuil pour faire une détection efficace, de manière à prendre en compte toutes les sources d'imprécision qui empêcheraient une détection ou qui, au contraire, provoqueraient une détection injustifiée.

En particulier, quelle que soit une cellule i de la batterie 10, des imprécisions peuvent survenir sur le calcul de la charge prévisionnelle à équilibrer $q_{i,bal}$ pour la cellule i. Ces imprécisions peuvent entre autres avoir pour origine :

- le capteur de tension mesurant la tension à courant nul $OCV_i$,
- un temps de relaxation insuffisant avant d'effectuer la mesure de la tension à courant nul $OCV_i$,
- les approximations de la cartographie contenant des valeurs de l'état de charge $SOC_i$ en fonction de la tension $OCV_i$,
- les approximations de l'obtention de l'état de santé SOH; qui ne peut être estimé qu'au moyen d'un calcul ou d'un modèle mathématique,
- les écarts de tolérance de la capacité $Q_i$ en sortie d'usine.

Dans les calculs, il doit être tenu compte des imprécisions précitées à la fois pour les grandeurs relatives à la cellule i mais aussi pour les grandeurs relatives à la cellule cible.

D'autres imprécisions peuvent survenir sur le calcul de la quantité de charge effectivement déchargée $\Delta q_i(T)$ par la cellule i au cours de l'intervalle de relaxation T.

Selon l'exemple illustré, quelle que soit une cellule i de la batterie 10, la quantité de charge effectivement déchargée $\Delta q_i(T)$ est donnée par l'équation :

$$\Delta q_i(T) = \frac{1}{R_{bal}} \int_0^T V_i(\tau) d\tau \quad (7)$$

Dans ce cas, les origines des imprécisions comprennent notamment :

- la variabilité de la résistance $R_{bal}$ qui peut changer avec la température,
- le capteur de tension mesurant la tension aux bornes de la cellule i.

Quelle que soit une cellule i de la batterie 10, la quantité de charge effectivement déchargée $\Delta q_i(T)$ peut aussi être obtenue par l'équation :

$$\Delta q_i(T) = I_{bal} \times t_{i,bal} \quad (11)$$

Dans ce cas, les origines des imprécisions comprennent en particulier l'écart entre le courant d'équilibrage $I_{bal}$ mesuré par un capteur de courant et supposé égal pour toutes les cellules, et le véritable courant d'équilibrage $I_{i,bal}$ traversant la cellule i.
Au vu de ce qui précède, on définit dans l'exemple illustré, quelle que soit une cellule i, un seuil $\varepsilon_i$ regroupant toutes les imprécisions évoquées ci-dessus. Pour calculer le seuil $\varepsilon_i$, on détaille comment calculer l'erreur $\delta q_{i,bal}$ sur la charge prévisionnelle à équilibrer pour la cellule i et l'erreur $\delta \Delta q_i(T)$ sur la quantité de charge effectivement déchargée pour la cellule i.
Quelle que soit une cellule i de la batterie 10, à partir de l'équation :

$$q_{i,bal} = SOC_i \times Q_i - SOC_{cible} \times Q_{cible} \quad (2)$$

on peut développer la différentielle d'ordre 1 de la charge prévisionnelle à équilibrer pour la cellule i :

$$dq_{i,bal} = \frac{\partial}{\partial SOC_i}(SOC_i \times Q_i)dSOC_i + \frac{\partial}{\partial Q_i}(SOC_i \times Q_i)dQ_i$$
$$+ \frac{\partial}{\partial SOC_{cible}}(-SOC_{cible} \times Q_{cible})dSOC_{cible}$$
$$+ \frac{\partial}{\partial Q_{cible}}(-SOC_{cible} \times Q_{cible})dQ_{cible} \quad (19)$$

Cette équation peut être simplifiée de la manière suivante :

$$dq_{i,bal} = Q_i dSOC_i + SOC_i dQ_i - Q_{cible}dSOC_{cible} - SOC_{cible}dQ_{cible} \quad (20)$$

Quelle que soit une cellule i de la batterie 10, l'erreur $\delta q_{i,bal}$ sur la charge prévisionnelle à équilibrer pour la cellule i se calcule ainsi de la manière suivante :

$$\delta q_{i,bal} = |Q_i . \delta SOC_i| + |SOC_i . \delta Q_i| + |Q_{cible} . \delta SOC_{cible}| + |SOC_{cible} . \delta Q_{cible}| \quad (21)$$

où $\delta SOC_i$ désigne l'erreur sur l'état de charge de la cellule i, $\delta Q_i$ désigne l'erreur sur la capacité de la cellule i, $\delta SOC_{cible}$ désigne l'erreur sur l'état de charge de la cellule cible et $\delta Q_{cible}$ désigne l'erreur sur la capacité de la cellule cible.
L'équation ci-dessus pour calculer l'erreur $\delta q_{i,bal}$ est valable pour les instants $t_1$ et $t_2$. Par exemple, quelle que soit une cellule i de la batterie 10, une erreur de 3 % sur l'état de charge $SOC_i$ estimée de manière générale revient à substituer les $\delta SOC_i$ par 0,03. Il en est de même pour les $\delta Q_i$.
Pour obtenir un calcul encore plus précis de l'erreur $\delta q_{i,bal}$, on peut encore décomposer les erreurs $\delta Q_i$ et $\delta SOC_i$ à partir de l'équation :

$$q_{i,bal} = f(OCV_i) \times (SOH_i \times Q_{i,nom}) - f(OCV_{cible}) \times (SOH_{cible} \times Q_{cible,nom}) \quad (4)$$

Dans ce cas, quelle que soit une cellule i de la batterie 10, l'état de charge $SOC_i$ étant calculé après relaxation de la cellule i à partir de la tension à courant nul, l'erreur $\delta SOC_i$ provient de :

- un temps de relaxation insuffisant avant d'effectuer la mesure de la tension à courant nul $OCV_i$,
- le capteur de tension mesurant la tension à courant nul $OCV_i$,
- les approximations de la cartographie contenant des valeurs de l'état de charge $SOC_i$ en fonction de la tension $OCV_i$, pour laquelle la sensibilité $dOCV/dSOC$ change en fonction de la tension $OCV_i$ car elle est une fonction non linéaire.

Concernant l'erreur $\delta\Delta q_i(T)$ sur la quantité de charge effectivement déchargée, quelle que soit une cellule i de la batterie 10, on peut obtenir la quantité $\Delta q_i(T)$ par l'équation :

$$\Delta q_i(T) = \frac{1}{R_{bal}} \int_0^T v_i(\tau)d\tau \quad (7)$$

A partir de cette expression, on peut développer la différentielle d'ordre 1 de la quantité de charge effectivement déchargée pour la cellule i :

$$d\Delta q_i(T) = \frac{\partial\Delta q_i(T)}{\partial R_{bal}}dR_{bal} + \frac{\partial\Delta q_i(T)}{\partial \Upsilon}d\Upsilon, \text{ où } \Upsilon \triangleq \int_0^t v_i(\tau)\,d\tau \quad (22)$$

Cette équation peut être simplifiée de la manière suivante :

$$d\Delta q_i(T) = \frac{-1}{R_{bal}^2}\Upsilon dR_{bal} + \frac{1}{R_{bal}}d\Upsilon \quad (23)$$

Quelle que soit une cellule i de la batterie 10, l'erreur $\delta\Delta q_i(T)$ sur la quantité de charge effectivement déchargée pour la cellule i se calcule ainsi de la manière suivante :

$$\delta\Delta q_i(T) = \left|\frac{1}{R_{bal}^2}\Upsilon.\delta R_{bal}\right| + \left|\frac{1}{R_{bal}}.\delta\Upsilon\right| \quad (24)$$

où $\delta R_{bal}$ désigne l'erreur sur la résistance d'équilibrage $R_{bal}$ et $\delta\Upsilon$ désigne l'erreur sur la tension aux bornes de la cellule i.
L'erreur $\delta\Upsilon$ sur la tension aux bornes de la cellule i est essentiellement un bruit blanc. En conséquence, dans l'exemple de mise en œuvre illustré, on suppose l'erreur $\delta\Upsilon$ égale à zéro.
On peut également obtenir la quantité $\Delta q_i(T)$ par l'équation :

$$\Delta q_j(T) = I_{bal} \times t_{i,bal} \quad (11)$$

On obtient, en développant la différentielle d'ordre 1 :

$$d\Delta q_i(T) = \frac{\partial\Delta q_i(T)}{\partial I_{bal}}dI_{bal} + \frac{\partial\Delta q_i(T)}{\partial T}dT \quad (25)$$

Quelle que soit une cellule i de la batterie 10, l'erreur $\delta\Delta q_i(T)$ sur la quantité de charge effectivement déchargée pour la cellule i peut alors se calculer de la manière suivante :

$$\delta\Delta q_i(T) = |T.\delta I_{bal}| + |I_{bal}.\delta T| \quad (26)$$

où $\delta I_{bal}$ désigne l'erreur sur l'intensité d'équilibrage et $\delta T$ désigne l'erreur sur le temps d'équilibrage.
L'erreur $\delta T$ peut normalement être considérée comme nulle car négligeable.

Au vu de ce qui précède, quelle que soit une cellule i de la batterie 10, on peut calculer l'erreur $\delta\Delta q_i(T)$ en appliquant l'une des deux équations simplifiées ci-dessous :

$$\delta\Delta q_i(T) = \left| \frac{1}{R_{bal}^2} \Upsilon . \delta R_{bal} \right| \quad (27)$$

et

$$\delta\Delta q_i(T) = |T . \delta I_{bal}| \quad (28)$$

Quelle que soit une cellule i de la batterie 10, à partir de l'équation :

$$\Sigma_i = q_{i,bal}(t_2) + \Delta q_i(T) - q_{i,bal}(t_1) \quad (15)$$

on peut écrire l'équation permettant de calculer le bilan $\Sigma_i$ en tenant compte des erreurs précédemment présentées :

$$\Sigma_i = \left( q_{i,bal}(t_2) \pm \delta q_{i,bal}(t_2) \right) + \left( \Delta q_i(T) \pm \delta\Delta q_i(T) \right)$$
$$- \left( q_{i,bal}(t_1) \pm \delta q_{i,bal}(t_1) \right) \quad (29)$$

L'équation (29) peut aussi s'écrire :

$$\Sigma_i = \left( q_{i,bal}(t_2) + \Delta q_i(T) - q_{i,bal}(t_1) \right)$$
$$\pm \left( \delta q_{i,bal}(t_2) + \delta\Delta q_i(T) + \delta q_{i,bal}(t_1) \right) \quad (30)$$

Le seuil $\varepsilon$ doit donc être défini comme suit :

$$\varepsilon = \delta q_{i,bal}(t_2) + \delta\Delta q_i(T) + \delta q_{i,bal}(t_1) \quad (31)$$

en utilisant les expressions précédemment écrites des erreurs $\delta q_{i,bal}(t_1)$, $\delta q_{i,bal}(t_2)$ et $\delta\Delta q_i(T)$.

On a donc décrit comment détecter un défaut d'autodécharge dans l'une quelconque des cellules de la batterie 10, en théorie et en pratique. En référence à la figure 2, le procédé selon l'invention comprend une troisième phase P03 de calcul du bilan des charges $\Sigma_i$ par utilisation de l'équation (15), une quatrième phase P04 de calcul du seuil $\varepsilon_i$ par utilisation des équations (31), (21), (27) et (28). Le procédé comporte enfin une cinquième phase P05 de comparaison du bilan $\Sigma_i$ avec le seuil $\varepsilon_i$. Si, lors de la phase P05, quelle que soit une cellule i, le bilan $\Sigma_i$ est supérieur ou égal au seuil $\varepsilon_i$, alors un défaut d'autodécharge pour la cellule i est détecté. Par ailleurs, au cours de la phase P05, on met en œuvre le test précité pour détecter si la cellule cible comporte un défaut d'autodécharge, en regardant si la condition de l'équation (18) est remplie.

L'utilisation du seuil ainsi calculé permet d'éviter l'absence de détection d'un défaut d'autodécharge et la fausse détection d'un défaut d'autodécharge inexistant. En particulier, le seuil $\varepsilon_i$ est adapté pour tenir compte de la plupart des imprécisions impactant les cellules d'une batterie d'accumulation électrique, en particulier du type incorporant un véhicule automobile à propulsion électrique. On maximise ainsi la fiabilité du procédé de détection selon l'invention.

De manière générale, le procédé selon l'invention permet de détecter un défaut d'autodécharge dans une cellule de la batterie à un stade précoce et sans ajouter de dispositif matériel, simplement en effectuant des modifications logicielles.

En particulier, le procédé selon l'invention ne nécessite pas de comparer les états de charge des cellules après une longue période de relaxation. Le procédé selon l'invention permet ainsi d'accélérer la détection d'un défaut d'autodécharge, de sorte que cette détection peut être mise en œuvre de manière plus fréquente et donc à un stade plus précoce.

**Revendications**

1. Procédé de détection, dans une batterie d'accumulation électrique (10) comportant une pluralité de cellules (1, 2, 3, 4) de batterie, d'un défaut d'autodécharge dans une cellule (1, 2, 3, 4), dans lequel :

   - on met en œuvre au moins partiellement un équilibrage des charges des cellules (1, 2, 3, 4) de batterie
   **caractérisé en ce que**
   - on réalise une relaxation des cellules (1, 2, 3, 4) de batterie,
   - on calcule, pour chaque cellule (i) de batterie, un bilan des charges au cours de l'équilibrage et de la relaxation ($\Sigma_i$) de ladite cellule (i), et
   - on détecte, pour chaque cellule (i) de batterie, s'il existe un défaut d'autodécharge de ladite cellule (i) en fonction du bilan des charges au cours de l'équilibrage et de la relaxation ($\Sigma_i$) calculé pour ladite cellule (i).

2. Procédé selon la revendication 1, dans lequel, pour chaque cellule (i) de batterie, on calcule le bilan des charges au cours de l'équilibrage et de la relaxation ($\Sigma_i$) de ladite cellule (i) en tenant compte d'au moins une grandeur choisie parmi la charge à équilibrer ($q_{i,bal}(t_1)$) pour ladite cellule (i) immédiatement avant le début de l'équilibrage de ladite cellule (i), la charge à équilibrer ($q_{i,bal}(t_2)$) pour ladite cellule (i) immédiatement après la fin de la relaxation de ladite cellule (i), la quantité de charge déchargée ($\Delta q_i(T)$) pour ladite cellule (i) au cours de l'équilibrage.

3. Procédé selon la revendication 2, dans lequel, quelle que soit une cellule (i) de batterie, on calcule le bilan des charges au cours de l'équilibrage et de la relaxation ($\Sigma_i$) de ladite cellule (i) en appliquant la relation suivante :

$$\Sigma_i = q_{i,bal}(t_2) + \Delta q_i(T) - q_{i,bal}(t_1)$$

   où « $\Sigma_i$ » désigne le bilan des charges au cours de l'équilibrage et de la relaxation de ladite cellule (i),
   « $q_{i,bal}(t)$ » désigne la charge à équilibrer pour ladite cellule (i) à un instant t,
   « $\Delta q_i(T)$ » désigne la quantité de charge déchargée pour ladite cellule (i) pendant un intervalle T,
   « $t_1$ » désigne un instant situé immédiatement avant le début de l'équilibrage de ladite cellule (i),
   « $t_2$ » désigne un instant situé immédiatement après la fin de la relaxation de ladite cellule (i), et
   « T » désigne la durée pendant laquelle l'équilibrage des charges de la cellule (i) a été mis en œuvre.

4. Procédé selon l'une quelconque des revendications 1 à 3, dans lequel, pour chaque cellule (i), l'équilibrage comprend une étape (E02) de calcul d'une charge à équilibrer ($q_{i,bal}$) pour ladite cellule, et une étape (E03) de mise en œuvre de l'équilibrage dans laquelle on calcule la quantité de charge déchargée ($\Delta q_i(t)$) pour ladite cellule (i), et on poursuit l'étape (E03) d'équilibrage tant que la charge à équilibrer ($q_{i,bal}$) pour ladite cellule (i) est strictement supérieure à la quantité de charge déchargée ($\Delta q_i(t)$) pour ladite cellule (i).

5. Procédé selon l'une quelconque des revendications 1 à 3, dans lequel, pour chaque cellule (i), l'équilibrage comprend une étape (E02) de calcul d'une charge à équilibrer ($q_{i,bal}$) pour ladite cellule (i), une étape (E02) de calcul d'un temps d'équilibrage ($t_{i,bal}$) de ladite cellule (i) en fonction de la charge à équilibrer ($q_{i,bal}$) pour ladite cellule (i) calculée, et dans lequel on met en œuvre l'équilibrage pendant le temps d'équilibrage ($t_{i,bal}$) calculé.

6. Procédé selon l'une quelconque des revendications 1 à 5, dans lequel on calcule, pour chaque cellule (i), une charge à équilibrer ($q_{i,bal}$) pour ladite cellule en fonction d'au moins un paramètre choisi parmi un état de charge ($SOC_i$) de ladite cellule (i), un état de charge ($SOC_{cible}$) d'une cellule cible, une capacité ($Q_i$) de ladite cellule (i), une capacité ($Q_{cible}$) d'une cellule cible, un état de santé ($SOH_i$) de ladite cellule (i), un état de santé ($SOH_{cible}$) d'une cellule cible, une tension à courant nul ($OCV_i$) de ladite cellule (i), une tension à courant nul ($OCV_{cible}$) d'une cellule cible, une capacité nominale ($Q_{i,nom}$) de ladite cellule (i) et une capacité nominale ($Q_{cible,nom}$) d'une cellule cible, et/ou dans lequel on calcule, pour chaque cellule (i), une quantité de charge déchargée ($\Delta q_i(T)$) pendant une durée (T) pour ladite cellule (i) en fonction d'au moins un paramètre choisi parmi une résistance d'équilibrage ($R_{bal}$), une tension ($v_i(t)$) aux bornes de ladite cellule (i) à un instant (t) appartenant à ladite durée (T), une intensité d'équilibrage ($I_{bal}$) des cellules (1, 2, 3, 4) de la batterie d'accumulation électrique (10) et une tension nominale ($V_{nom}$) des cellules (1, 2, 3, 4) de la batterie d'accumulation électrique (10).

**7.** Procédé selon l'une quelconque des revendications 1 à 6, dans lequel on détecte qu'il existe un défaut d'autodécharge dans une première cellule de batterie si, quelle que soit une seconde cellule (i) de batterie autre que la première cellule de batterie, la charge à équilibrer ($q_{i,bal}(t_2)$) par ladite seconde cellule (i) immédiatement après la fin de la relaxation de ladite seconde cellule (i) est strictement supérieure à la charge à équilibrer ($q_{i,bal}(t_1)$) par ladite seconde cellule (i) immédiatement avant le début de l'équilibrage de ladite seconde cellule (i) et la quantité de charge déchargée ($\Delta q_i(T)$) par ladite seconde cellule (i) au cours de l'équilibrage et de la relaxation est différente de zéro.

**8.** Procédé selon l'une quelconque des revendications 1 à 7, dans lequel, pour chaque cellule (i), on détecte qu'il existe un défaut d'autodécharge dans ladite cellule (i) si le bilan des charges au cours de l'équilibrage et de la relaxation ($\Sigma_i$) calculé pour ladite cellule (i) dépasse un seuil ($\varepsilon_i$) strictement positif, ledit seuil ($\varepsilon_i$) étant déterminé en fonction d'au moins une erreur choisie parmi une erreur sur la charge à équilibrer ($\delta q_{i,bal}(t_1)$) pour ladite cellule (i) immédiatement avant le début de l'équilibrage de ladite cellule (i), une erreur sur la charge à équilibrer ($\delta q_{i,bal}(t_2)$) pour ladite cellule (i) immédiatement après la fin de la relaxation de ladite cellule (i), une erreur sur la quantité de charge déchargée ($\delta \Delta q_i(T)$) pour ladite cellule (i) au cours de l'équilibrage et de la relaxation.

**9.** Procédé selon la revendication 8, dans lequel, quelle que soit une cellule (i), ledit seuil ($\varepsilon_i$) est déterminé en fonction d'une erreur sur la charge à équilibrer ($\delta q_{i,bal}$) pour ladite cellule (i), ladite erreur ($\delta q_{i,bal}$) étant calculée, pour tout instant (t), selon l'expression suivante :

$$\delta q_{i,bal} = |Q_i.\delta SOC_i| + |SOC_i.\delta Q_i| + |Q_{cible}.\delta SOC_{cible}| + |SOC_{cible}.\delta Q_{cible}|$$

où « $\delta q_{i,bal}$ » représente l'erreur sur la charge à équilibrer par ladite cellule (i) audit instant,
« $\delta SOC_i$ » représente l'erreur sur l'état de charge de ladite cellule (i),
« $\delta Q_i$ » représente l'erreur sur la charge de ladite cellule (i),
« $SOC_i$ » représente l'état de charge de ladite cellule (i) audit instant (t),
« $Q_i$ » représente la charge de ladite cellule (i) audit instant (t),
« $\delta SOC_{cible}$ » représente l'erreur sur l'état de charge de la cellule cible,
« $\delta Q_{cible}$ » représente l'erreur sur la charge de la cellule cible,
« $SOC_{cible}$ » représente l'état de charge de la cellule cible audit instant (t), et
« $Q_{cible}$ » représente la charge de la cellule cible audit instant (t).

**10.** Procédé selon la revendication 8 ou 9, dans lequel, quelle que soit une cellule (i), ledit seuil est déterminé en fonction d'une erreur sur la quantité de charge déchargée ($\delta \Delta q_i(T)$) pour ladite cellule (i) pendant un intervalle (T), ladite erreur ($\delta \Delta q_i(T)$) étant calculée en utilisant au moins l'une des expressions suivantes :

$$\delta \Delta q_i(T) = \left| \frac{1}{R_{bal}{}^2} . \int_0^T V_i(\tau)\, d\tau . \delta R_{bal} \right|$$

et

$$\delta \Delta q_i(T) = |T.\delta I_{bal}|$$

où « T » représente ledit intervalle,
« $\delta \Delta q_i(T)$ » représente l'erreur sur la quantité de charge déchargée pour ladite cellule (i) pendant ledit intervalle (T),
« $R_{bal}$ » représente la résistance utilisée pour l'équilibrage,
quel que soit un instant $\tau$ appartenant audit intervalle, « $V_i(\tau)$ » désigne la tension mesurée aux bornes de ladite cellule (i) à l'instant T,
« $\delta I_{bal}$ » représente l'écart de tolérance du courant d'équilibrage des cellules (1, 2, 3, 4) de la batterie d'accumulation électrique (10).

**Patentansprüche**

1. Verfahren zur Erkennung eines Selbstentladungsdefekts in einer Zelle (1, 2, 3, 4) in einer elektrischen Speicherbatterie (10), die eine Vielzahl von Batteriezellen (1, 2, 3, 4) umfasst, wobei:

   - zumindest teilweise ein Ladeausgleich der Batteriezellen (1, 2, 3, 4) durchgeführt wird, **dadurch gekennzeichnet, dass**
   - eine Relaxation der Batteriezellen (1, 2, 3, 4) realisiert wird,
   - für jede Batteriezelle (i) im Verlauf des Ausgleichs und der Relaxation ($\Sigma_i$) der Zelle (i) eine Ladebilanz berechnet wird und
   - bei jeder Batteriezelle (i) in Abhängigkeit von der für die Zelle (i) berechnete Ladebilanz im Verlauf des Ausgleichs und der Relaxation ($\Sigma_i$) erkannt wird, ob ein Selbstentladungsdefekt der Zelle (i) vorliegt.

2. Verfahren nach Anspruch 1, wobei für jede Batteriezelle (i) die Ladebilanz im Verlauf des Ausgleichs und der Relaxation ($\Sigma_i$) der Zelle (i) unter Berücksichtigung mindestens einer Größe berechnet wird, die aus der bei der Zelle (i) auszugleichenden Ladung ($q_{i,bal}(t_1)$) unmittelbar vor Beginn des Ausgleichs der Zelle (i), der bei der Zelle (i) auszugleichenden Ladung ($q_{i,bal}(t_2)$) unmittelbar nach Ende der Relaxation der Zelle (i), der Menge der entladenen Ladung ($\Delta q_i(T)$) der Zelle (i) im Verlauf des Ausgleichs ausgewählt wird.

3. Verfahren nach Anspruch 2, wobei bei gleich welcher Batteriezelle (i) die Ladebilanz im Verlauf des Ausgleichs und der Relaxation ($\Sigma_i$) der Zelle (i) durch Anwenden der folgenden Beziehung berechnet wird:

$$\Sigma_i = q_{i,bal}(t_2) + \Delta q_i(T) - q_{i,bal}(t_1)$$

   wobei "$\Sigma_i$" die Ladebilanz im Verlauf des Ausgleichs und der Relaxation der Zelle (i) bezeichnet,
   "$q_{i,bal}(t)$" die auszugleichende Ladung für die Zelle (i) zu einem Zeitpunkt t bezeichnet,
   "$\Delta q_i(T)$" die Menge der entladenen Ladung der Zelle (i) während eines Intervalls T bezeichnet,
   "$t_1$" einen Zeitpunkt bezeichnet, der unmittelbar vor Beginn des Ausgleichs der Zelle (i) liegt,
   "$t_2$" einen Zeitpunkt bezeichnet, der unmittelbar nach Ende der Relaxation der Zelle (i) liegt und
   "T" die Dauer bezeichnet, während der der Ladeausgleich der Zelle (i) durchgeführt wurde.

4. Verfahren nach einem der Ansprüche 1 bis 3, wobei bei jeder Zelle (i) der Ausgleich einen Schritt (E02) zur Berechnung einer auszugleichenden Ladung ($q_{i,bal}$) für die Zelle und einen Schritt (E03) zur Durchführung des Ausgleichs, bei dem die Menge der entladenen Ladung ($\Delta q_i(t)$) der Zelle (i) berechnet wird, umfasst und der Ausgleichsschritt (E03) solange durchgeführt wird, wie die auszugleichende Ladung ($q_{i,bal}$) für die Zelle (i) streng größer ist als die Menge der entladenen Ladung ($\Delta q_i(t)$) der Zelle (i).

5. Verfahren nach einem der Ansprüche 1 bis 3, wobei bei jeder Zelle (i) der Ausgleich einen Schritt (E02) zur Berechnung einer auszugleichenden Ladung ($q_{i,bal}$) für die Zelle (i), einen Schritt (E02) zur Berechnung einer Ausgleichszeit ($t_{i,bal}$) der Zelle (i) in Abhängigkeit von der berechneten auszugleichenden Ladung ($q_{i,bal}$) für die Zelle (i) umfasst und wobei der Ausgleich während der berechneten Ausgleichszeit ($t_{i,bal}$) durchgeführt wird.

6. Verfahren nach einem der Ansprüche 1 bis 5, wobei für jede Zelle (i) eine auszugleichende Ladung ($q_{i,bal}$) für die Zelle in Abhängigkeit von mindestens einem Parameter berechnet wird, der aus einem Ladezustand ($SOC_i$) der Zelle (i), einem Ladezustand ($SOC_{cible}$) einer Zielzelle, einer Kapazität ($Q_i$) der Zelle (i), einer Kapazität ($Q_{cible}$) einer Zielzelle, einem Gesundheitszustand ($SOH_i$) der Zelle (i), einem Gesundheitszustand ($SOH_{cible}$) einer Zielzelle, einer Nullstromspannung ($OCV_i$) der Zelle (i), einer Nullstromspannung ($OCV_{cible}$) einer Zielzelle, einer Nennkapazität ($Q_{i,nom}$) der Zelle (i) und einer Nennkapazität ($Q_{cible,nom}$) einer Zielzelle ausgewählt wird, und/oder wobei für jede Zelle (i) eine Menge der entladenen Ladung ($\Delta q_i(T)$) während einer Dauer (T) für die Zelle (i) in Abhängigkeit von mindestens einem Parameter berechnet wird, der aus einem Ausgleichswiderstand ($R_{bal}$), einer Spannung ($v_i(t)$) an den Klemmen der Zelle (i) zu einem Zeitpunkt (t) der Dauer (T), einer Ausgleichsstärke ($I_{bal}$) der Zellen (1, 2, 3, 4) der elektrischen Speicherbatterie (10) und einer Nennspannung ($V_{nom}$) der Zellen (1, 2, 3, 4) der elektrischen Speicherbatterie (10) ausgewählt wird.

7. Verfahren nach einem der Ansprüche 1 bis 6, wobei erkannt wird, ob ein Selbstentladungsdefekt in einer ersten Batteriezelle vorliegt, wenn mit gleich welcher zweiten Batteriezelle (i), die von der ersten Batteriezelle verschieden ist, die von der zweiten Zelle (i) auszugleichende Ladung ($q_{i,bal}(t_2)$) unmittelbar nach Ende der Relaxation der zweiten Zelle (i) streng größer ist als die von der zweiten Zelle (i) auszugleichende Ladung ($q_{i,bal}(t_1)$) unmittelbar vor Beginn des Ausgleichs durch die zweite Zelle (i) und die Menge der von der zweiten Zelle (i) entladenen Ladung ($\Delta q_i(T)$) im Verlauf des Ausgleichs und der Relaxation ungleich null ist.

8. Verfahren nach einem der Ansprüche 1 bis 7, wobei bei jeder Zelle (i) erkannt wird, ob ein Selbstentladedefekt in der Zelle (i) vorliegt, wenn die für die Zelle (i) berechnete Ladebilanz im Verlauf des Ausgleichs und der Relaxation ($\Sigma_i$) einen streng positiven Schwellenwert ($\varepsilon_i$) überschreitet, wobei der Schwellenwert ($\varepsilon_i$) in Abhängigkeit von mindestens einem Fehler bestimmt wird, der aus einem Fehler bezüglich der auszugleichenden Ladung ($\delta q_{i,bal}(t_1)$) für die Zelle (i) unmittelbar vor Beginn des Ausgleichs der Zelle (i), einem Fehler bezüglich der auszugleichenden Ladung ($\delta q_{i,bal}(t_2)$) für die Zelle (i) unmittelbar nach Ende der Relaxation der Zelle (i), einem Fehler bezüglich der Menge der entladenen Ladung ($\delta \Delta q_i(T)$) der Zelle (i) im Verlauf des Ausgleichs und der Relaxation ausgewählt wird.

9. Verfahren nach Anspruch 8, wobei bei gleich welcher Zelle (i) der Schwellenwert ($\varepsilon_i$) in Abhängigkeit von einem Fehler bezüglich der auszugleichenden Ladung ($\delta q_{i,bal}$) für die Zelle (i) bestimmt wird, wobei der Fehler ($\delta q_{i,bal}$) für jeden Zeitpunkt (t) nach folgendem Ausdruck berechnet wird:

$$\delta q_{i,bal} = \left| Q_i . \delta SOC_i \right| + \left| SOC_i . \delta Q_i \right| + \left| Q_{cible} . \delta SOC_{cible} \right| + \left| SOC_{cible} . \delta Q_{cible} \right|$$

wobei "$\delta q_{i,bal}$" den Fehler bezüglich der Ladung, die zum Zeitpunkt durch die Zelle (i) auszugleichen ist,
"$\delta SOC_i$" den Fehler bezüglich des Ladezustands der Zelle (i) darstellt,
"$\delta Q_i$" den Fehler bezüglich der Ladung der Zelle (i) darstellt,
"$SOC_i$" den Ladezustand der Zelle (i) zum Zeitpunkt (t) darstellt,
"$Q_i$" die Ladung der Zelle (i) zum Zeitpunkt (t) darstellt,
"$\delta SOC_{cible}$" den Fehler bezüglich des Ladezustands der Zielzelle darstellt,
"$\delta Q_{cible}$" den Fehler bezüglich der Ladung der Zielzelle darstellt,
"$SOC_{cible}$" den Ladezustand der Zielzelle zum Zeitpunkt (t) darstellt und
"$Q_{cible}$" die Ladung der Zielzelle zum Zeitpunkt (t) darstellt.

10. Verfahren nach Anspruch 8 oder 9, wobei bei gleich welcher Zelle (i) der Schwellenwert in Abhängigkeit von einem Fehler bezüglich der Menge der entladenen Ladung ($\delta \Delta q_i(T)$) der Zelle (i) während eines Intervalls (T) bestimmt wird, wobei der Fehler ($\delta \Delta q_i(T)$) unter Anwendung mindestens eines der folgenden Ausdrücke berechnet wird:

$$\delta \Delta q_i(T) = \left| \frac{1}{R_{bal}^2} . \int_0^T V_i(\tau)\, d\tau . \delta R_{bal} \right| \quad und \quad \delta \Delta q_i(T) = \left| T . \delta I_{bal} \right|$$

wobei "T" das Intervall darstellt,
"$\delta \Delta q_i(T)$" den Fehler bezüglich der Menge der entladenen Ladung der Zelle (i) während des Intervalls (T) darstellt,
"$R_{bal}$" den angewandten Widerstand für den Ausgleich gleich zu welchem Zeitpunkt $\tau$ des Intervalls darstellt,
"$V_i(\tau)$" die Spannung bezeichnet, die zum Zeitpunkt $\tau$ an den Klemmen der Zelle (i) gemessen wird.
"$\delta I_{bal}$" die Toleranzabweichung des Ausgleichstroms der Zellen (1, 2, 3, 4) der elektrischen Speicherbatterie (10) darstellt.

**Claims**

1. Method for detecting, in an electric storage battery (10) having a plurality of battery cells (1, 2, 3, 4), a self-discharge defect in a cell (1, 2, 3, 4), wherein:

   - a balancing of the charges of the battery cells (1, 2, 3, 4) is carried out, at least partially, **characterized in that**
   - a relaxation of the battery cells (1, 2, 3, 4) is carried out,
   - for each battery cell (i), a charge balance during the balancing and relaxation ($\Sigma_i$) of said cell (i) is calculated, and
   - the possible existence of any self-discharge defect of said cell (i) is detected for each battery cell (i) on the basis of the charge balance during the balancing and relaxation ($\Sigma_i$) calculated for said cell (i) .

2. Method according to Claim 1, wherein, for each battery cell (i), the charge balance during the balancing and relaxation ($\Sigma_i$) of said cell (i) is calculated with allowance for at least one magnitude chosen from among the charge to be balanced ($q_{i,bal}(t_1)$) for said cell (i) immediately before the start of the balancing of said cell (i), the charge to be balanced ($q_{i,bal}(t_2)$) for said cell (i) immediately after the end of the relaxation of said cell (i), and the amount of charge discharged ($\Delta q_i(T)$) for said cell (i) during the balancing.

3. Method according to Claim 2, wherein, for any battery cell (i), the charge balance during the balancing and relaxation ($\Sigma_i$) of said cell (i) is calculated by applying the following relationship:

$$\Sigma_i \; = \; q_{i,bal}(t_2) \; + \; \Delta q_i(T) \; - \; q_{i,bal}(t_1)$$

where "$\Sigma_l$" denotes the charge balance during the balancing and relaxation of said cell (i),
"$q_{i,bal}(t)$" denotes the charge to be balanced for said cell (i) at an instant t,
"$\Delta q_i(T)$" denotes the amount of charge discharged for said cell (i) during an interval T,
"$t_1$" denotes an instant located immediately before the start of the balancing of said cell (i),
"$t_2$" denotes an instant located immediately after the end of the relaxation of said cell (i), and
"T" denotes the period during which the balancing of the charges of the cell (i) has been executed.

4. Method according to any of Claims 1 to 3, wherein, for each cell (i), the balancing comprises a step (E02) of calculating a charge to be balanced ($q_{i,bal}$) for said cell and a step (E03) of executing the balancing in which the amount of charge discharged ($\Delta q_i(t)$) for said cell (i) is calculated, and the balancing step (E03) is continued as long as the charge to be balanced ($q_{i,bal}$) for said cell (i) is strictly greater than the amount of charge discharged ($\Delta q_i(t)$) for said cell (i).

5. Method according to any of Claims 1 to 3, wherein, for each cell (i), the balancing comprises a step (E02) of calculating a charge to be balanced ($q_{i,bal}$) for said cell (i) and a step (E02) of calculating a balancing time ($t_{i,bal}$) of said cell (i) on the basis of the calculated charge to be balanced ($q_{i,bal}$) for said cell (i), in which the balancing is executed during the calculated balancing time ($t_{i,bal}$) .

6. Method according to any of Claims 1 to 5, wherein, for each cell (i), a charge to be balanced ($q_{i,bal}$) for said cell is calculated on the basis of at least one parameter chosen from among a state of charge ($SOC_i$) of said cell (i), a state of charge ($SOC_{target}$) of a target cell, a capacity ($Q_i$) of said cell (i), a capacity ($Q_{target}$) of a target cell, a state of health ($SOH_i$) of said cell (i), a state of health ($SOH_{target}$) of a target cell, a zero current voltage ($OCV_i$) of said cell (i), a zero current voltage ($OCV_{target}$) of a target cell, a nominal capacity ($Q_{i,nom}$) of said cell (i) and a nominal capacity ($Q_{target,nom}$) of a target cell, and/or wherein, for each cell (i), an amount of charge discharged ($\Delta q_i(T)$) during a period (T) for said cell (i) is calculated on the basis of at least one parameter chosen from among a balancing resistance ($R_{bal}$), a voltage ($v_i(t)$) at the terminals of said cell (i) at an instant (t) belonging to said period (T), a balancing current ($I_{bal}$) of the cells (1, 2, 3, 4) of the electric storage battery (10), and a nominal voltage ($V_{nom}$) of the cells (1, 2, 3, 4) of the electric storage battery (10).

7. Method according to any of Claims 1 to 6, wherein the possible presence of a self-discharge defect in a first battery cell is detected if, for any second battery cell (i) other than the first battery cell, the charge to be balanced ($q_{i,bal}(t_2)$) by said second cell (i) immediately after the end of the relaxation of said second cell (i) is strictly greater than the charge to be balanced ($q_{i,bal}(t_1)$) by said second cell (i) immediately before the start of the balancing of said second cell (i), and the amount of charge discharged ($\Delta q_i(T)$) by said second cell (i) during the balancing and relaxation is other than zero.

8. Method according to any of Claims 1 to 7, wherein, for each cell (i), the possible presence of a self-discharge defect in said cell (i) is detected if the calculated charge balance for said cell (i) during the balancing and relaxation ($\Sigma_i$) exceeds a strictly positive threshold ($\varepsilon_1$), said threshold ($\varepsilon_1$) being determined on the basis of at least one error chosen from among an error on the charge to be balanced ($\delta q_{i,bal}(t_1)$) for said cell (i) immediately before the start of the balancing of said cell (i), an error on the charge to be balanced ($\delta q_{i,bal}(t_2)$) for said cell (i) immediately after the end of the relaxation of said cell (i), and an error on the amount of charge discharged ($\delta \Delta q_i(T)$) for said cell (i) during the balancing and relaxation.

9. Method according to Claim 8, wherein, for any cell (i), said threshold ($\varepsilon_i$) is determined on the basis of an error on the charge to be balanced ($\delta q_{i,bal}$) for said cell (i), said error ($\delta q_{i,bal}$) being calculated, for any instant (t), according to the following expression:

$$\delta q_{i,bal} = |Q_i.\delta SOC_i| + |SOC_i.\delta Q_i| + |Q_{target}.\delta SOC_{target}| + |SOC_{target}.\delta Q_{target}|$$

where "$\delta q_{i,bal}$" represents the error on the charge to be balanced by said cell (i) at said instant,
"$\delta SOC_i$" represents the error on the state of charge of said cell (i),
"$\delta Q_i$" represents the error on the charge of said cell (i),
"$SOC_i$" represents the state of charge of said cell (i) at said instant (t),
"$Q_i$" represents the charge of said cell (i) at said instant (t),
"$\delta SOC_{target}$" represents the error on the state of charge of the target cell,
"$\delta Q_{target}$" represents the error on the charge of the target cell,
"$SOC_{target}$" represents the state of charge of the target cell at said instant (t), and
"$Q_{target}$" represents the charge of the target cell at said instant (t).

10. Method according to Claim 8 or 9, wherein, for any cell (i), said threshold is determined on the basis of an error on the amount of charge discharged ($\delta\Delta q_i(T)$) for said cell (i) during an interval (T), said error ($\delta\Delta q_i(T)$) being calculated by using at least one of the following expressions:

$$\delta\Delta q_i(T) = \left|\frac{1}{R_{bal}^2}.\int_0^T V_i(\tau)d\tau.\delta R_{bal}\right| \qquad \text{and} \quad \delta\Delta q_i(T) = |T.\delta I_{bal}|$$

where "T" represents said interval,
"$\delta\Delta q_i(T)$" represents the error on the amount of charge discharged for said cell (i) during said interval (T),
"$R_{bal}$" represents the resistance used for the balancing,
for any instant $\tau$ belonging to said interval, "$V_i(\tau)$" denotes the voltage measured at the terminals of said cell (i) at the instant $\tau$, and
"$\delta I_{bal}$" represents the permitted deviation of the balancing current of the cells (1, 2, 3, 4) of the electric storage battery (10).

EP 3 655 788 B1

# FIG.1

# FIG.2

# FIG.3

## FIG.4

## FIG.5

## RÉFÉRENCES CITÉES DANS LA DESCRIPTION

**Documents brevets cités dans la description**

- CN 105527583
- AU 2004203624
- DE 102012214878
- CN 106908727